Europäisches Patentamt

European Patent Office

Office européen des brevets

(19)

(11) Publication number: **0 045 191**
A1

# (12) EUROPEAN PATENT APPLICATION

(21) Application number: **81303399.0**

(22) Date of filing: **24.07.81**

(51) Int. Cl.³: **C 30 B 25/18,** C 01 B 33/02, C 30 B 29/06

(30) Priority: **28.07.80 US 172508**

(43) Date of publication of application: **03.02.82**
**Bulletin 82/5**

(84) Designated Contracting States: **BE CH DE FR GB IT LI NL**

(71) Applicant: **MONSANTO COMPANY, Patent Department 800 North Lindbergh Boulevard, St. Louis, Missouri 63166 (US)**

(72) Inventor: **Burd, John William, 130 Winfield Drive, Spartanburg South Carolina 29302 (US)**
Inventor: **Gutsche, Henry William, 1659 Pepperwood Drive, St. Louis Missouri 63141 (US)**

(74) Representative: **Lunt, John Cooper et al, Monsanto House 10-18 Victoria Street, London, SW1H ONQ (GB)**

(54) **Process and apparatus for the production of semiconductor bodies.**

(57) In a process for preparing a body of semiconductor material in which a slim rod (19) of semiconductor material in a chemical vapor deposition chamber (23) is maintained in contact with decomposable gaseous compounds containing semiconductor material at a temperature sufficient for decomposing the gaseous compounds whereby decomposition of the gaseous compounds occurs and semiconductor material is deposited on the slim rod to form an enlarged semiconductor body, a virgin slim rod (19) is pulled in a pulling chamber (9) from a molten semiconductor material source (17) using a seed crystal, the slim rod, maintained at a temperature sufficient for decomposing the said gaseous compounds, is passed continuously into the chemical vapor deposition chamber (23) through a communication passageway (21) between the pulling chamber and the deposition chamber, and the enlarged semiconductor body (33) is pulled continuously from the decomposition chamber.

- 1 -

PROCESS AND APPARATUS FOR THE PRODUCTION
OF SEMICONDUCTOR BODIES

This invention relates to apparatus and process for producing electronic-grade semiconductor bodies wherein continuously-pulled slim rod which can be formed in situ from the reaction of a seed crystal and a molten semiconductor material source with the slim rod being pulled into and through a chemical vapor deposition chamber, the slim rod surface being preheated before entry into the deposition chamber where it is simultaneously exposed to focused heating and thermally decomposable gaseous compounds in order to provide suitable surface reaction conditions on the slim rod for the decomposition of the gaseous compounds which results in deposition growth upon the surface of the rod. In another aspect the invention relates to single crystal semiconductor bodies produced by avoiding poly-growth conditions through the in situ continuously pulled virgin slim rod, preheating of the slim rod for entry into the chemical vapor deposition chamber wherein the rods are simultaneously heated or maintained at reaction temperature conditions while being exposed or contacted with elected thermally decomposable gaseous compounds and continuously drawn through the chemical vapor deposition chamber reaction zone resulting in an enlarged single crystal semiconductor body which is withdrawn continuously from the chemical vapor deposition

C19-21-0282

0045191

chamber.

In the semiconductor industry, it is common to deposit material from the gaseous state onto a substrate for the purpose of forming various electronic devices. In some applications the material deposition from the gas is the same material as that from which the substrate is formed, while in other instances it is a different material from that from which the substrate is formed. As an example of the former, in the growth of silicon by vapor deposition techniques, it is common to position an elongated silicon filament between two graphite electrodes each of which extends through the end of a quartz container within which the filament is placed. A potential is impressed across the graphite electrodes causing a current to flow through the filament. The resistance of the filament to current flow elevates the temperature of the filament to a temperature generally in excess of about $1100^{\circ}$ centigrade.

A gas stream, which comprises a mixture of trichlorosilane and hydrogen and/or other silanes is introduced into the quartz chamber and after flowing along the longitudinal axis of the filament is withdrawn from the chamber. The gas stream, upon contacting the hot surface silicon filament, will react to deposit polycrystalline silicon on the filament, thus increasing the diameter of the filament. The reaction of the trichlorosilane and hydrogen may be generally illustrated by the following simplified formula:

$$SiHCl_3 + H_2 \rightarrow Si + 3\ HCl$$

Gas flow through the quartz cylinder or reaction chamber is usually continued for several hours to increase the diameter of the filament, which may be 2.5 mm.

in diameter upon commencement of the deposition, to a diameter in excess of 125 mm. When the silicon rod has reached a desired diameter, the flow is terminated and the rod is removed from the reaction chamber. This process is known as the Siemens process. Material deposited on the silicon filament will be polycrystalline and therefore must be remelted to produce a

C19-21-0282

0045191

single crystalline material. Alternatively, the poly crystal rod may be melted in a crucible and a large single rod is "pulled" from the melt by way of a variety of apparatus such as a "Czochralski" puller.

In both commercially accepted methods of producing single crystal silicon for the electronics industry, that is by float zone or by Czochralski, the single crystal rod which is drawn from a melt in both cases is rotated and results from pulling the melt in the form of the single crystal rod. Such methods require considerable skilled technician monitoring as well as multiple furnaces requiring substantial energy for operation. Even under the best conditions, frequently irregularly shaped cylindrical rods are produced requiring substantial and expensive pre-machining before slicing and conversion into wafers for use in the electronics industry.

Recent developments in the semiconductor industry have created a growing demand for low-cost single crystal silicon of extremely high purity, which is known as semiconductor grade silicon. Semiconductor grade silicon is used in the manufacture of semiconductor devices, integrated circuit and discrete devices such as transistors, rectifiers, solar cells, and the like. Processes are in use in the prior art producing single crystal silicon through the remelting of polycrystalline semiconductor grade silicon.

The prior art processes have demonstrated the technical and economic feasibility of producing high purity polycrystalline silicon of semiconductor quality by hydrogen reduction of silicon halides. All commercial semiconductor polycrystalline silicon presently being manufactured through chemical vapor deposition process employs hydrogen reduction of dichlorosilane or trichlorosilane and the deposition of silicon on electrically heated silicon or metal. In addition, it has been known since the early 1960's that single crystal silicon of exceptional purity and nearly ideal compositional homogeneity can be grown epitaxially by chemical vapor deposition (CVD). The contiguous growth of single crystal silicon on a single crystal substrate from the gas phase is known and is based on the reduction of volatile silicon derivatives with hydrogen at elevated temperatures. It is also known to utilize volatile acceptor or donor impurity precursors during the growth process which are added, thus leading to the formation of electrically-active regions, bounded by junctions of varying thicknesses, carrier concentrations, and junction profiles. Vapor substrate growth systems are quite general and in principle applicable to systems in which are provided pertinent kinetic and thermodynamic conditions of satisfactory balance.

The growth of single crystal silicon from the vapor phase is dependent on several important parameters, all of which interreact with each other to some degree. These parameters can be described in part, for example, as substrate surface crystallographic orientation, the chemical system, reaction variables, such as concentration, pressure, temperature modification, and the appropriate kinetic and thermodynamic factors. A variety of reaction systems have been investigated; however, all have the common feature that a hot single crystal surface is exposed to an atmosphere where thermally and/or chemically interreaction is capable of producing silicon atoms on a hot surface. The mechanism of the silicon-forming reaction is mainly a function of the temperature of the substrate.

In addition known epitaxial CVD processes using trichlorosilane have been demonstrated to achieve high conversion yields and have shown that single crystal deposition does occur at rapid linear growth rates. It is further known that p-n junctions with theoretical I-V characteristics have been grown by CVD indicating the superiority of directly deposited from the vapor phase (CVD) single crystal silicon over melt grown silicon. However, practical application of chemical vapor deposition to the preparation of bulk single crystal semiconductor bodies has not been extended to the commercial preparation of rod shaped bodies but has been limited to the preparation of thin epitaxial films on substrate in wafer form. All attempts at preparing thick, rod shaped, large single crystal bodies on electrically heated single crystal filaments consisting of the same material have failed, mainly because of the unresolved difficulties with preparing and maintaining a practically contamination-free substrate seed surface. In addition all previous attempts at developing commercial processes for the direct deposition of rod-shaped single crystal bodies for device applications have failed since strictly electrical means were insufficient to provide the temperature uniformity essential to deposit a flawless single crystal body of homogeneous composition. Both a near perfect single crystal structure and homogeneous chemical composition are conditions without which a semiconductor device constructed by means of that single crystal body will not function properly.

### Summary of the Invention

To overcome the difficulties cited above, the invention provides a process and apparatus for preparing electronic grade semiconductor bodies from continuously pulled slim rod formed in situ from the reaction of a seed crystal and a molten semiconductor material source, pulled into and through a chemical vapor deposition chamber, the slim rod surface being heated before entry into the chamber and simultaneously exposed to further heating and selected thermally decomposable gaseous compounds resulting in deposition growth of the body.

In accordance with the principles of the invention, the CVD approach was directed to bulk single crystal operation. Such an approach would not only eliminate the need for melt processing but also has the potential for producing a much improved product. The present apparatus utilized in the standard Siemens' process decomposer employing two or more free-standing filaments or slim rods providing substrate surfaces is inappropriate for the present invention since this apparatus is unsuited for the purpose of growing single crystals. While in the epitaxial process, major emphasis is placed in providing temperatures as uniform as possible across each substrate as well as from "wafer-to-wafer", no such temperature control has been achieved in the case of silicon single crystal, i.e., hex rod production. As a consequence of the negative resistivity co-efficient of silicon, all current heated silicon is hottest on the inside. Temperature differentials between the surface and core of silicon bodies of about 100 degrees centigrade have been observed. The core begins to melt when the surface temperatures exceed approximately 1300 degrees centigrade. Also the flat areas of "hex rods" are always hotter (10 to 50 degrees centigrade) than the corners and the flat areas facing another rod can be 10 to 50 degrees hotter than the "flat" facing outside, i.e. the cooler decomposer wall. These large temperature gradients naturally lead to thermal stress and lineage arrangement of excessive dislocation generation.

The starting slim rod surface in these prior efforts was usually chemically etched, a condition which has been proven to be particularly poor for good epitaxial growth and all attempts to vapor etch the slim rod in hydrogen or hydrochloric acid while helpful also "cleaned" the decomposer inside which resulted in the deposition of varying impure "skins" on the slim rod. The initial deposit always showed a deep dip in resistivity as well as a tell-tale ring when cross sections were treated with preferential etches. This direct layer next to the original slim rod has always led to what came to be believed "inevitable" chevron growth, i.e., stacking fault originated polycrystalline inserts in the otherwise single crystal "hex" rod. What is overcome by the present invention are the shortcomings mentioned in the two previous paragraphs by employing a continuous feed of slim rod which has an as-pulled, "virgin" surface into a tubular decomposer chamber. While slowly moving through the decomposer chamber, the slim rod is uniformly heated by focused heating means having a concentrated heat flux to the center line of the decomposer chamber which is also the center line of the slim rod and the growing semiconductor body. Only part of the necessary heat will be supplied to the slim rod by passing a current through it, specifically during the preheat stage before the slim rod is introduced into the decomposer chamber.

The apparatus and process according to the invention produces electronic-grade semiconductor bodies, specifically the invention is directed in part to electronic-grade semiconductor single crystal materials, for example, silicon. Following the single crystal silicon aspect of the invention, a slim rod pulling chamber is provided wherein a virgin silicon slim rod is formed in situ from the reaction of the seed crystal and a molten silicon material source with the slim rod being pulled from the growth chamber through a communication zone of the growth chamber with a chemical vapor deposition chamber wherein the slim rod surface which has been preheated in the growth chamber is simultaneously exposed to focused heating and thermally decomposable silicon containing gaseous compounds. The apparatus according to the invention is designed specifically for single crystal growth as opposed to the Siemens' decomposer chambers as discussed hereinabove; therefore the apparatus according to the invention is directed to provide a virgin silicon slim rod under suitable conditions for producing the most desirable reaction conditions for the silicon containing gaseous compounds with the result of single crystal silicon being deposited and grown on the slim rod as the slim rod is continuously pulled through the chemical vapor deposition chamber. Single crystal silicon vapor deposition is a very complex process. The present invention has utilized apparatus and methods which based upon identification and quantification of conditions are necessary to produce excellent quality single crystal silicon as the result of intelligently controlling various variables in the process. Unlike much of today's methods in producing single crystal silicon, which depends in good part upon trial and error approaches, the present invention is based on the proper approach of qualifying conditions under which good single crystal silicon body can be produced through the direct thermal decomposition of selected silanes and halogenated silanes.

Brief Description of the Drawings

FIG. 1 is an elevated somewhat schematic view of an apparatus useful in the practice of the invention;

FIG. 2 is a somewhat similar view embodying an expansion bellows-type chamber; and

FIG. 3 is an elevated somewhat schematic view of yet another apparatus useful in the practice of the invention.

Description of the Preferred Embodiments

The invention provides a process and apparatus for depositing semiconductor materials, such as an elemental silicon, from a reactive gas capable of pyrolytically

C19-21-0282
0045191

depositing the semiconductor material onto a heated, in situ drawn virgin seed rod under conditions which promote single crystal deposition rates allowing for continuous drawing of the rod through a chemical vapor deposition chamber.

The thermodynamics of a silicon-chlorine-hydrogen system are generally understood. The equilibrium compositions are fully quantified; however the kinetics of silicon chemical vapor deposition (CVD) are very poorly understood and multiple reactions appear to occur. Quantitatively, it is known that the deposition rate rises rapidly with temperature, is less sensitive to temperature at high temperatures and drop with further increase in temperature. Mass transfer and heat transfer in silicon CVD systems utilizing radiant heating have not previously been well understood and continue to be evasive of exact quantification.

The single crystal silicon chemical vapor deposition process according to the invention can be simply described as growth of a single crystal from a mixture of gases containing silicon such as halogenated silanes and/or silane and hydrogen at elevated temperatures. Behind this simple description a number of complex phenomena remain for the most part unresolved. Chemical thermodynamics establishes the maximum attainable yields which depends on temperature and initial molar ratios. Various gas phase and gas/solid reactions are involved, the kinetics of which depend on temperature, gas composition, and crystal orientation. Adsorption-desorption of reaction end products on crystal surfaces is also temperature dependant as are the rates of crystal growth nucleation. Finally, the gas composition and temperature on the crystal surface are affected by the flow pattern in the reactor which determines mass transport and heat transfer.

In the following description of the invention, the process will be described on the basis of producing elemental, single crystal silicon from a reaction gas mixture, comprised of hydrogen, and halogenated silanes, preferably trichlorosilane. However, this is for convenience only and the invention may also be practiced with other thermally decomposable semiconductor compounds capable of yielding selected semiconductor materials. For silicon sources such as tetrachlorosilane, tetrabromosilane, tribromosilane, for example, as well as other suitable thermally decomposable compounds may be used.

The term "continuous" as used herein and in the claims is defined as the pulling of an in situ virgin slim rod from the pulling chamber directly into and through the chemical deposition chamber whether the pulling is absolutely continuous or in stop and go motion. The concept "continuous" as defined herein is to illustrate the fact that the semiconductor bodies are produced on a virgin slim rod fashioned continuously and moved through the chemical vapor deposition chamber without break in the production scheme, with finished product being drawn from the chemical vapor deposition chamber either into the upper chamber storage area or into the atmosphere where it can be scribed and broken or sawed and removed from the continuously produced rod. The process according to the invention can be continuous in motion or can be continuous with intermittant motion through the respective chambers. In another aspect the continuous process can be defined as drawing the seed rod into and through the chemical vapor deposition chamber with a period of stop motion for growth of the semiconductor body and thereafter removing that rod segment from the chemical vapor deposition chamber which simultaneously loads the chamber with new virgin seed rod.

The in situ produced virgin slim rod or seed rod can be the result of a seed float-zone or Czochralski silicon melt source which is made available in the pulling chamber. In the case of float-zone, the continuous supply rod can be fed through the bottom portion of the pulling chamber in a continuous mode depending upon the requirements for seed rod production as the seed rod is pulled into and through the chemical vapor deposition chamber. In addition the slim rod is heated prior to entry into the chemical vapor deposition chamber and its pathway is clearly defined through a sleeve mechanism which is of sufficient diameter to allow the slim rod to pass therethrough without touching. The restrictive nature of the sleeve and communication passageway between the pulling chamber and the chemical vapor deposition chamber permits open communication for passage of the slim rod; however it does not permit substantial gas transfer between the two chambers. According to the invention a positive pressure exists in the pulling chamber which comprises hydrogen or helium or some other suitable inert gas which will not interfere with the reaction gas thermal decomposition process of the CVD chamber. This positive pressure permits, for example, hydrogen to enter into the CVD chamber in very small amounts which will not interfere with the reaction gas thermodynamics or kinetics of depositing silicon upon the heated slim rod.

The pulling of a virgin silicon slim rod of single crystal composition is necessary in order to insure elimination of many of the causes for poly growth in a CVD chamber. For example, commercially pulled single crystal slim rods are chemically etched or prepared by other known methods and have been found to contain sufficient surface contamination or defect problems which lead to substantial poly formation upon the decomposition of the reaction gases in the CVD chamber. It should be noted however that the invention can always be unitized for the production of polycrystalline silicon if such end result is desired. In fact, it may be highly desirable for the following reasons: The present poly requirement for removing the slim rod or filament from an external slim rod puller to the reaction chamber thereby exposing the virgin surface of the slim rod to handling in the atmospheric environment inevitably causes impurities from the environment as well as particular matter to be lodged in form of an adsorbed layer on the surface. From this surface neither the adsorbed atomic or molecular species nor the particulate matter can be removed completely by pre-deposition vapor etching. The reason for this phenomenon is obvious yet often overlooked. The virgin surface on the slim rod when pulled in a hydrogen or inert gas atmosphere is covered with nothing else but hydrogen or that inert gas. With an impurity concentration of practically zero on such a surface, substantially all substances in the universe will experience a nearly infinitely large chemical potential for attraction to this surface. During this bombardment with impurities including particular matter, an approximately 50 Angstrom $SiO_2$ film is forming on the silicon surface trapping and holding the impurities with tenacity. Experience further has shown that this natural first oxide on a silicon crystal is highly resistant to available vapor etching methods. During the following deposition of silicon from the CVD reaction the first layer will therefore be impurity-rich and affected by numerous point defects which will cause polycrystalline growth in selected areas.

It follows therefore that in the traditional Siemens process for the preparation of semiconductor grade polycrystal silicon in which externally prepared slim rods serve as substrate, there are always highly contaminated initial layers with trapped impurities which severely limit the potential of the Siemens process to prepare ultimate degrees of purity of the product silicon. This means that the process and apparatus disclosed in this invention is also extremely useful in the preparation of polycrystalline silicon rod of superior purity, for example, as needed for float zone feed. The method is also applicable to other semiconductor substances which are required in extreme purity, and are preferred in monocrystalline form, for example in the manufacture of electronic semiconductor devices such as rectifiers, transistors, solar cells, photo cells, and the like. The method is suited to the production of highly purified germanium, and semiconducting compounds of elements from the third and fifth groups of the periodic system to form such compounds as $BN$, $BP$, $BAs$, $BSb$, $AlN$, $AlP$, $AlAs$, $AlSb$, $GaP$, $GaAs$, $GaSb$, $InN$, $InP$, $InAs$, $InSb$, and the like. The process can also be utilizable for the meltless production of other desirable substances particularly metals and metals compounds having high melting points.

Once the virgin slim rod which has been preheated and drawn into and through the CVD chamber, the rod is simultaneously exposed to focused heating and in the case of silicon, silicon-containing decomposable gaseous compounds. The CVD chamber is arranged in such a manner as to afford continuous focused heated in a geometrical manner on the rod for substantially the entire length of the chamber. The method of heating has to provide sufficient energy to maintain the substrate surface temperature between 1,000°C. and 1,300°C., preferably 1,150°C.-1,250°C., at all times and has to provide sufficiently uniform heating to the substrate so that the surface temperature does not vary. more than about $\pm$ 10$^{o}$C., preferably $\pm$ 5$^{o}$C. or less, along the entire deposition area.

Various gas feed arrangements can be utilized in the CVD chamber with one preferred embodiment inclusive of a countercurrent flow of reaction gas as opposed to the continuous movement of the slim rod and/or growing body. The process according to the invention does not require rotation of the slim rod or of the drawing body which is generally the case of modern remelt methods; however, if desired, rotation of the growing body could be utilized according to the invention when, for example, an improvement of deposition uniformity is desired.

In the continuous process and apparatus for producing semiconductor bodies from slim rod through the utilization of a CVD chamber, the withdrawal of the grown body or of silicon hex rod can be achieved by various means. One suitable means is through a gas lock which incorporates movement of the hexagonal body to a restricted zone wherein it first contacts one reactive gas jet thereafter followed by contact with a vacuum zone and thirdly an inert gas jet. These various gas-vacuum zones can be repeated, the number according to the need. Such gas seal means are achievable because of the relatively low pressure of the reaction gas system within CVD reaction chamber. The gas seal means also permits various shaped articles, i.e. cylindrical, irregular shaped cylindrical and hexagonal configurations to pass through a restricted mechanical barrier without touching the barrier. In addition these gas seal means zones can be utilized for initial cooling of the growth body as it leaves the reaction chamber and enters into atmospheric conditions or storage conditions. Once the growth body has been drawn for a distance somewhat removed from the CVD chamber and gas seal means in the atmosphere, the body can be scribed, snapped, broken or sawed from the continuously pulled growth body source, the separation depending on temperature of the growth body at the point of separation and lack of mechanical shock to the continuously growing body system.

In another embodiment of the invention, the growth body is pulled from the CVD chamber through a mechanically restricted zone which permits withdrawal of the body without touching the walls of said zone with the body being drawn into an expansion chamber comprised of for example a bellows expansion chamber which permits the growth body to achieve various lengths outside the CVD chamber depending upon the length of the bellows apparatus. One advantage of such a system permits the cool down of the rod to be achieved in controlled atmospheric conditions. The bellows storage chamber process would necessitate eventual temporary shutdown of the continuous process; however such shutdown would not necessarily contaminate the system for restart achieved by thermal build up and reaction gas introduction to the CVD chamber after an inert gas purge. Here again the CVD chamber is at a relatively low pressure during operation and positive pressure can be maintained between the CVD chamber and the bellows reception chamber during continuous growth and during shutdown removal of the grown body.

In another version of the slim rod puller, reaction chamber, bellows storage chamber assembly, a gas seal means could be provided between the deposition chamber and the bellows storage chamber thus eliminating the need for any interruption of the deposition process during removal of the product rod from the bellows storage chamber.

Before discussing the various apparatus illustrated in the drawings which are useful for practicing the invention it is to be noted that a main feature of the invention is to allow one to select specific deposition rates at an optimum value and to maintain this value during the entire deposition process in a continuous mode. In that regard, it is desirable to select the deposition rate as large as possible, but in so doing to also insure that neither homogeneous nucleation of, for example, silicon, in the free gas phase nor deposition of silicon on the interior walls of the CVD chamber occurs. In addition the utilization of a virgin silicon slim rod prepared in situ creates the best possible deposition surface for creating single crystal silicon bodies.

The preferred embodiments of the apparatus and process to be employed for the purpose of the invention are schematically illustrated in the drawings.

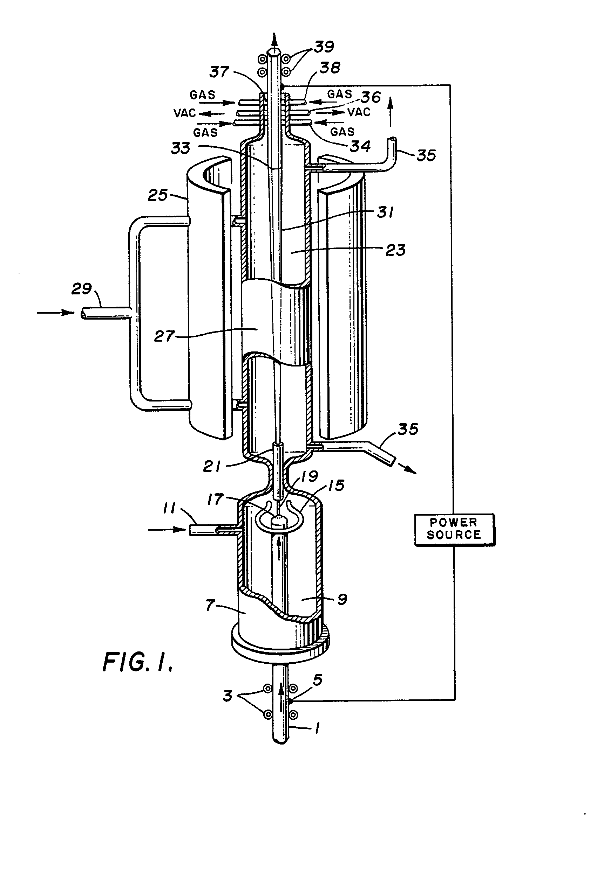

In Figure 1, a source feed rod of polycrystalline silicon 1 having a direct current connection 5 is automatically fed through means 3 in through seal means 7 into the virgin seed rod pulling chamber 9. The direct current connection 5 is utilized for resistive preheating of the virgin seed rod or slim rod 19 before entry into the chemical vapor deposition chamber 23. The source rod seal means 7 can be of various constructions which allow longitudinal transport into a pressurized chamber. The slim rod pulling chamber 9 is equipped with chamber inlet gas facilities 11 which maintains a positive pressure upon the pulling chamber 9 utilizing for example hydrogen or helium or some other suitable gas which is inert to the thermal decomposition reactions which occur in the CVD chamber 23. Pulling chamber 9 may be vented by outlet means; however the positive pressure should be maintained.

The source feed rod 1 provides a source rod melt 17 through utilization of a high energy heating coil 15, for example, similar to physical conditions utilized in commercial float zone technology. The virgin slim rod 19 is produced through the action of a single crystal seed and drawing of same from the source rod melt 17. The virgin slim rod 19 is continuously pulled from the pulling chamber 9 into and through the CVD chamber 23 through a communication zone between chambers 9 and 23 comprised of a quartz sleeve 21 which serves the purpose of reducing temperature loss of the CVD chamber and in combination with the positive pressure of the pulling chamber 9 prohibits process or reaction gas loss from CVD chamber 23. In addition the quartz sleeve 21 in the restrictive communication zone between the two chambers prohibits contact of the seed rod 19 with the process gas in the CVD chamber 23 until ideal reaction conditions exist which occur upon entry into the CVD chamber 23 through the simultaneous focused heating from the radiant heat furnace 25 in combination with CVD chamber 23 transparent walls 27 and contacting of the slim rod 19 with process gas from inlets 29. The process gas inlets can be arranged in interior circular dispersion heads which encompass the growth rod and can enter the CVD chamber 23 at various points along the chamber walls. The resulting hexagonal silicon body 31 increases in diameter as it proceeds through the CVD chamber 23 reaching a maximum rod diameter 33 at the upper portion of chamber 23. The continuous process and the apparatus according to Figure 1 provide a gas seal means 37 at the upper end of chamber 23 which permits continuous drawing of the enlarged hexagonal body from the chamber without loss of process gas or contamination of the CVD chamber. The continuous motion of the seed rod and the growth rod is achieved through automatic rod pulling means 39 which are exterior to the CVD chamber 23.

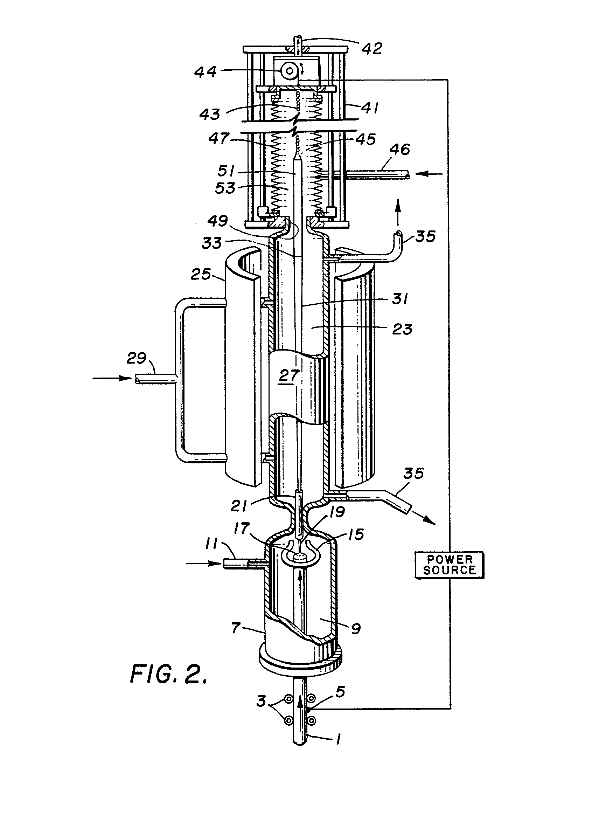

The CVD chamber 23 utilizes a different apparatus for withdrawing the hexagonal body 31 as illustrated in Figure 2. The apparatus of Figure 2 provides a bellows and receiving chamber mechanism 41 which is comprised of a bellows expansion chamber 47 in communication with the CVD chamber 23 through a restricted passageway 49. The grown hexagonal rod upper portion 51 exits through the passageway 49 into bellows chamber 47 which expands away from CVD chamber 23 by expansion means 42 in order to accommodate the continuous pulled hexagonal body 31. The pulling apparatus inclusive of seed puller means 43, take up means 44, and seed 45, is affixed to the upper end portion of product rod 51. The bellows receiving chamber 49 permits the pulling of the product rod 31 from the CVD chamber 23 without need for consideration of loss of product gas or contamination from outside sources of the CVD chamber. The three chambers, pulling chamber 7, CVD chamber 23 and bellows receiving chamber 47 are all in open communication with one another and yet isolated from atmospheric conditions and contamination. The expandability of the bellows mechanism 41 permit considerable continuous production of hexagonal body 31 without stoppage. Upon reaching the maximum expansion of the bellows 41, the process can be shut down and the hexagonal rod 31 removed from the bellows chamber.

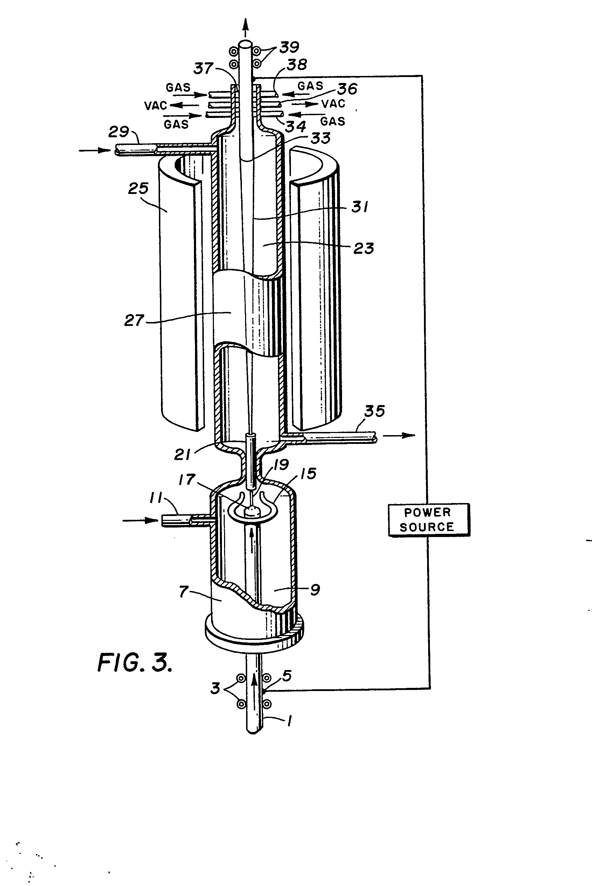

Figure 3 illustrates a simplistic form of a countercurrent process gas to seed rod flow utilizing the CVD chamber 23 and a gas seal means 37. The process gas inlet 29 is in the approximate vicinity of the hex rod maximum diameter zone and provides for flow down the CVD chamber 23 and exit through off gas outlet 35 which is in the approximate vicinity of the quartz sleeve 21 entry zone of seed rod 19. Such a countercurrent flow of process gas provides the maximum reactive surface to the maximum amount of reactive gas at the upper end of the CVD chamber thus providing a preferred efficiency arrangement having a significant impact upon deposition rate.

The gas seal means 37 first creates a positive reactive gas pressure in the restricted exit zone of hexagonal body 31 followed by a vacuum zone in close proximity which is then followed by an inert gas positive pressure zone. These alternate zone inputs and vacuum zones can be repeated as units until a sufficient gas seal means is achieved. In addition the gas seal means can be utilized for providing initial cooling of the hexagonal body 31 before external product rod pulling means 39 pulls the hexagonal rod 31 from the CVD chamber into atmospheric conditions.

In the following examples the invention will be more fully described, but it should be understood that these examples are given by way of illustration and not as a limitation.

## EXAMPLE 1

A substrate slim rod 0.4 cm in diameter was produced from a silicon feed rod 2.0 cm in diameter, the top of which was melted by an R.F. (radio frequency) coil by first dipping a single crystal seed affixed to a chuck suspended from a bead chain into the melt and then retracting the seed by winding the bead chain onto a motor-driven pick-up reel. This "pulling" of the substrate slim rod was continued until the slim rod filled the entire length of the reaction chamber. This reaction chamber consisted of a single-walled, 12.7 x 112 cm. cylindrical quartz tube closed at both ends by suitable metal flanges with pass-throughs for the slim rod, the gases, etc. A radiant-heat furnace enveloped the reaction chamber and was used to heat the slim rod to approximately 1,200°C. The length of the radiant heat furnace was 61 cm. In addition, a current of 20 amperes was passed through the slim rod to maintain those parts of the slim rod which are outside the radiant heat furnace at approximately 1,200°C. to avoid heat loss through conduction through the slim rod. This arrangement allows the establishment of a uniform heat zone over about 51 cm. length within the 61 cm. length of the furnace. The principal heat source consists of the 24 tungsten-iodine quartz lamps in the radiant heat furnace which were operated at

a total voltage of 450 volt and a current of 75 amperes in this experiment.

A $SiHCl_3/H_2$ process gas consisting of 7.21 liters of $SiHCl_3$ vapor and 72.8 liters hydrogen was admitted to and passed through the reaction chamber for ten hours. The direction of the gas flow was from the top down. The exhaust was located at the lower metal flange. The result of this experiment was a single crystal of silicon in the form of a six-sided cylinder. The diameter of this crystal was 11.4 mm which computes to a radial deposition rate R of 6.2 microns per minute. The crystal structure showed only 2,600 dislocation pits per $cm^2$ after cross-sectioning the crystal and Sirtl-etching the resulting wafer. The average surface temperature during deposition was $1200^{\circ}C$. as recorded.

Example 2

In another experiment the substrate temperature was adjusted to $1,165^{\circ}C$. This experiment resulted again in a hexagonal-shaped single crystal but at a slightly reduced radial deposition rate of 5.9 micron per minute.

Examples 3-5

In the same reaction chamber a series of experimental runs were carried out to determine what if any influence the total gas flow is having on the deposition rate. All runs yielded single crystal deposits from the tabulated data (Table 1).

Table 1.

| Examples | $SiHCl_3$ (liters/ min) | $H_2$ (liters/ min) | Total Flow (liters/ min) | $\sqrt{T.F.}$ | Dep. Rate (microns/ min) | Temperature $^{\circ}C$ |
|---|---|---|---|---|---|---|
| 1 | 7.2 | 72.8 | 80 | 8.94 | 6.2 | 1204 |
| 2 | 7.2 | 72.8 | 80 | 8.94 | 5.9 | 1165 |
| 3 | 0.9 | 9.1 | 10 | 3.16 | 3.9 | 1200 |
| 4 | 1.8 | 18.2 | 20 | 4.47 | 4.2 | 1192 |
| 5 | 3.6 | 36.4 | 40 | 6.32 | 4.9 | 1203 |

0045191

CLAIMS

1. A process for preparing a body of semiconductor material in which a slim rod of semiconductor material in a chemical vapor deposition chamber is maintained at a temperature sufficient to decompose gaseous compounds containing semiconductor material, and a reaction gas comprising the said compounds is introduced into the chemical vapor deposition chamber whereby decomposition of the gaseous compounds occurs and semiconductor material is deposited on the slim rod to form an enlarged semiconductor body, characterised in that a virgin slim rod is pulled in a pulling chamber from a molten semiconductor material source using a seed crystal, the slim rod, maintained at a temperature sufficient for decomposing the said gaseous compounds, is passed continuously into the chemical vapor deposition chamber through a communication passageway between the pulling chamber and the deposition chamber, and the enlarged semiconductor body is pulled continuously from the decomposition chamber.

2. A process according to Claim 1 wherein the slim rod upon entry into the chemical vapor deposition chamber and passage through the chamber is exposed to concentric, uniform heating through geometrically focusing heating means.

3. A process according to Claim 2 wherein the heating means is comprised of a radiant heat furnace surrounding the chamber and focusing the heat onto the slim rod through transparent walls of the chamber.

4. A process according to any of Claims 1 to 3 wherein a positive pressure is maintained between the slim rod pulling chamber and the chemical vapor deposition chamber, the positive pressure creating a gas flow from the pulling chamber into the chemical vapor deposition chamber.

5.    A process according to Claim 4 wherein the gas
forming the positive pressure from the pulling chamber
to the chemical vapor deposition chamber is selected from
hydrogen, helium, neon, argon, krypton, xenon, or radon.

6.    A process according to any of Claims 1 to 5 wherein
the pulling chamber is provided with a continuous source
of semiconductor material.

7.    A process according to any of Claims 1 to 6 wherein
the continuous movement of the slim rod into and through
the chemical vapor deposition chamber is countercurrent to
the decomposable gaseous compound flow.

8.    A process according to any of Claims 1 to 7 wherein
the enlarged semiconductor body exits the chemical vapor
deposition chamber through an exit means which provides
cooling of the semiconductor body before entry into
atmosphere storage zones.

9.    A process according to any of Claims 1 to 7 wherein
the enlarged semiconductor body exits from the chemical
vapor deposition chamber into an expandable chamber zone
which is in communication with the vapor deposition
chamber.

10.    A process according to any of Claims 1 to 9 wherein
the semiconductor material is silicon.

11.    Apparatus for the production of a body of semiconductor material, comprising a chemical vapor deposition
chamber having reaction gas entry and exit means,
characterised in that the apparatus also includes

         a.    a slim rod pulling chamber having an
         upper end in communication with the vapor
         deposition chamber lower end through a
         narrowed passageway of sufficient diameter
         to allow passage of the slim rod from the
         pulling chamber into the chemical vapor
         deposition chamber without touching, means
         at its lower end through which a continuous

- 23

feed of semiconductor material can be introduced into the pulling chamber, and high energy heating coil means to provide a melt of semiconductor material;

b. a withdrawable pulling means extending downward through the chemical vapor deposition chamber and into the pulling chamber;

c. means for maintaining the temperature of the slim rod in the pulling chamber;

d. a geometrically focusing radiant furance surrounding the chemical vapor deposition chamber walls, the chamber walls being transparent to the focused heat;

e. means for introducing gas into the pulling chamber to create a pressure therein; and

f. exit means from the chemical vapor deposition chamber upper end comprising a gas seal means.

12. Apparatus according to Claim 11 wherein the narrowed passageway providing communication between the pulling chamber and the chemical vapor deposition chamber is comprised of a quartz sleeve.

13. Apparatus according to either of Claims 11 and 12 wherein the chemical vapor deposition chamber upper end is comprised of an expansion member permitting the semiconductor material body to be drawn upwardly from the chemical vapor deposition chamber.

FIG. 1.

FIG. 2.

FIG. 3.

European Patent Office

**EUROPEAN SEARCH REPORT**

0045191
Application number

EP 81 30 3399

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | <u>GB - A - 1 112 140</u> (DOW CORNING)<br><br>* claims 1,5,9 and 10; page 2, column 1, lines 55 to 62; figure *<br><br>--- | 1,2,3, 6,8, 10,11 | C 30 B 25/18<br>C 01 B 33/02<br>C 30 B 29/06 |
| | <u>US - A - 3 152 022</u> (H. CHRISTEN-<br>SEN)<br><br>* claim 1; figure *<br><br>--------- | 1 | |

**TECHNICAL FIELDS SEARCHED (Int. Cl.³)**

C 30 B 25/18
     25/20
     29/06
C 01 B 33/02
C 30 B 25/10

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 11-11-1981 | BRACKE |

EPO Form 1503.1 06.78